# EUROPÄISCHE PATENTSCHRIFT

(11) **EP 2 630 267 B1**
(45) Veröffentlichungstag und Bekanntmachung des Hinweises auf die Patenterteilung: **22.07.2020**
(21) Anmeldenummer: 11713484.1
(22) Anmeldetag: 29.03.2011
(51) Int. Cl.: C22C 32/00, B22F 1/02, C22C 5/06, C22C 9/10, H01B 1/22

(54) **AUSGANGSWERKSTOFF FÜR EINE SINTERVERBINDUNG**
STARTING MATERIAL FOR A SINTERED JOIN
MATÉRIAU DE DÉPART D'UNE LIAISON FRITTÉE

(30) Priorität: 20.10.2010 DE 102010042721; 20.10.2010 DE 102010042702
(43) Veröffentlichungstag der Anmeldung: 28.08.2013
(73) Patentinhaber: Robert Bosch GmbH, 70442 Stuttgart (DE)
(72) Erfinder: WOLDE-GIORGIS, Daniel, 70771 Leinfelden-Echterdingen (DE); FEIOCK, Andrea, 72124 Pliezhausen (DE); KOLB, Robert, 64807 Dieburg (DE); KALICH, Thomas, 72805 Lichtenstein (DE)
(86) Internationale Anmeldenummer: PCT/EP2011/054845
(87) Internationale Veröffentlichungsnummer: WO 2012/052192

(56) Entgegenhaltungen:
- EP-A2- 1 383 361
- WO-A1-2010/081752
- US-A- 4 775 414
- PADELLA F ET AL: "Mechanical alloying of the Pd-Si system in controlled conditions of energy transfer", JOURNAL OF THE LESS-COMMON METALS, ELSEVIER-SEQUOIA S.A. LAUSANNE, CH, Bd. 175, Nr. 1, 20. September 1991 (1991-09-20), Seiten 79-90, XP024075043, ISSN: 0022-5088, DOI: DOI:10.1016/0022-5088(91)90351-4 [gefunden am 1991-09-20]

## Beschreibung

Die Erfindung betrifft einen Ausgangswerkstoff für eine Sinterverbindung.

### Stand der Technik

Leistungselektronik wird in vielen Bereichen der Technik eingesetzt. Gerade in elektrischen oder elektronischen Geräten, in welchen große Ströme fließen, ist der Einsatz von Leistungselektronik unumgänglich. Die in der Leistungselektronik notwendigen Stromstärken führen zu einer thermischen Belastung der enthaltenen elektrischen oder elektronischen Komponenten. Eine weitere thermische Belastung ist gegeben durch den Einsatz derartiger elektrischer oder elektronischer Geräte an Betriebsorten mit gegenüber der Raumtemperatur deutlich erhöhter und gegebenenfalls sogar ständig wechselnder Temperatur. Als Beispiele können hierfür Steuergeräte im Automobilbereich genannt werden, welche unmittelbar im Motorraum angeordnet sind.

Insbesondere viele Anbindungen zwischen Leistungshalbleitern beziehungsweise Integrierten Schaltungen (IC, englisch: integrated circuit) untereinander sowie an Trägersubstraten, unterliegen schon heute dauerhaften Temperaturbelastungen bis 175 Grad Celsius.

Üblicherweise erfolgt eine Anbindung von elektrischen oder elektronischen Komponenten - beispielsweise auf ein Trägersubstrat - durch eine Verbindungsschicht. Als eine derartige Verbindungsschicht sind Lotverbindungen bekannt.

Zumeist werden Weichlote eingesetzt, welche Zinn-Silber- oder Zinn-Silber-Kupfer-Legierungen basieren. Besonders bei Anwendungstemperaturen nahe der Schmelztemperatur zeigen derartige Verbindungsschichten jedoch schwindende elektrische und mechanische Eigenschaften, die zu einem Ausfall der Baugruppe führen können.

Bleihaltige Lotverbindungen sind bei höheren Einsatztemperaturen einsetzbar als Weichlotverbindungen. Bleihaltige Lotverbindungen sind jedoch durch gesetzliche Bestimmungen aus Gründen des Umweltschutzes hinsichtlich ihrer zulässigen technischen Anwendungen stark beschränkt.

Alternativ bieten sich für den Einsatz bei erhöhten beziehungsweise hohen Temperaturen, insbesondere über 200 Grad Celsius, bleifreie Hartlote an. Bleifreie Hartlote weisen in der Regel einen höheren Schmelzpunkt als 200°C auf. Bei der Verwendung von Hartlot zur Ausbildung einer Verbindungsschicht kommen jedoch nur wenige elektrische oder elektronische Komponenten als Fügepartner in Frage, die den hohen Temperaturen beim Schmelzen der Hartlote standhalten können.

Einen Ausweg zeigt die Niedertemperaturverbindungstechnologie (NTV) auf, bei der silberhaltige Sinterverbindungen bei bereits wesentlich geringeren Temperaturen als der Schmelztemperatur erzeugt werden können. Anstelle eines Lots wird hierbei eine Paste eingesetzt, die chemisch stabilisierte Silberpartikel und/oder Silberverbindungen enthält. Unter den Sinterbedingungen, insbesondere unter Temperatur- und Druckbeaufschlagung, werden dabei die stabilisierenden Bestandteile ausgebrannt und/oder die Silberverbindungen aufgebrochen, so dass die Silberpartikel beziehungsweise freigesetzten Silberatome untereinander und mit dem Material der Fügepartner in direkten Kontakt kommen. Durch Interdiffusion und/oder Diffusion kann dabei bei bereits deutlich geringeren Temperaturen als der Schmelztemperatur eine hochtemperaturstabile Verbindung ausgebildet werden. Unter Temperaturwechselbeanspruchung können jedoch bei derartigen Sinterverbindungen thermomechanische Spannungen und sogar eine Rissbildung in Halbleiterbauelementen oder sogar im Trägersubstrat auftreten.

Die Druckschrift DE 102009000192 A1 beschreibt eine Sinterwerkstoff zur Herstellung einer Sinterverbindung, welcher als Sinterpaste ausgebildet sein kann und metallische, mit einer organischen Beschichtung versehene Strukturpartikel sowie nicht organisch beschichtete metallische und/oder keramische beim Sinterprozess nicht ausgasende Hilfspartikel umfasst.

In der Offenlegungsschrift EP 1 383 361 A2 ist ein Schaltungsträger offenbart, der erhältlich ist unter Verwendung einer Kupfer-Paste zusammen mit einem keramischen Grünkörper, wobei die Kupfer-Paste ein Kupfer-Pulver, ein organisches Vehikel und ferner Siliziumdioxid umfassen kann.

In der Offenlegungsschrift US 4,775,414 (D2) wiederrum werden anorganische Klebstoffe offenbart, welche geeignet sein sollen, um ein Metall mit einem Metall, mit einer Keramik oder eine Keramik mit einer Keramik zu. Ein derartiger Klebstoff kann verschiedene Metallpartikel umfassen und ferner Siliziumpartikel und Siliziumcarbidpartikel aufweisen.

Aus der Offenlegungsschrift WO 2010/081752 (D3) ist ein Sinterwerkstoff bekannt. Um diesen auszubilden offenbart die gezeigte Ausführung, zusätzlich zu metallischen, mit einer organischen Beschichtung versehenen Strukturpartikeln, Hilfspartikel vorzusehen, die metallische und/oder keramische Partikel sind, und nicht organisch beschichtet sind.

### Offenbarung der Erfindung

Gegenstand der vorliegenden Erfindung ist ein Ausgangswerkstoff für eine Sinterverbindung gemäß den Merkmalen des Anspruchs 1.
Elementares Silicium und Siliciumdioxid weisen einen äußerst niedrigen thermischen Längenausdehnungskoeffizienten α (CTE, Englisch: Coefficient of Thermal Expansion) auf und haben sich unter anderem daher zur Verringerung des thermischen Längenausdehnungskoeffizienten der Sinterverbindung als besonders vorteilhaft erwiesen. Bereits durch die Zugabe einer geringen Menge kann daher vorteilhafterweise eine stärkere Verringerung des thermischen Längenausdehnungskoeffizienten der Sinterverbindung erzielt werden als durch andere Zusatzstoffe. Zudem weisen elementares Silicium und Siliciumdioxid vorteilhafterweise niedrige Young-Module auf, was sich vorteilhaft auf die Elastizität der Sinterverbindung auswirken kann. Durch eine Verringerung des thermischen Längenausdehnungskoeffizienten der Sinterverbindung sowie die guten elastischen Eigenschaften kann wiederum die thermomechanische Spannung zwischen der Sinterverbindung und dem damit verbundenen Halbleiterbauteil und damit die Tendenz zur Rissbildung des Halbleiterbauteils deutlich reduziert werden.
Aufgrund der günstigen Längenausdehnungskoeffizienten und Young-Module von elementarem Silicium beziehungsweise Siliciumdioxid kann vorteilhafterweise eine Sinterverbindung aus einem erfindungsgemäßen Ausgangswerkstoff einen geringeren Längenausdehnungskoeffizienten bei gleichem oder sogar geringeren Young-Modul aufweisen als eine gleichartige ungefüllte Sinterverbindung, insbesondere welche anstelle eines Anteils an zweiten Partikeln einen entsprechend größeren Anteil an ersten Partikeln aufweist. Vorteilhafterweise können durch den Einsatz von elementarem Silicium und/oder Siliciumdioxid zudem die Materialkosten verringert werden. Grundsätzlich verhalten sich Partikel aus elementarem Silizium und/oder Siliciumdioxid während einer Temperaturbehandlung des Ausgangswerkstoffes zur Ausbildung einer Sinterverbindung in vorteilhafter Weise chemisch inert und liegen bei einer gebildeten Sinterverbindung in unveränderter Form innerhalb der gebildeten Metallmatrix vor.

Grundsätzlich können sowohl amorphes als auch kristallines, insbesondere polykristallines, elementares Silicium und/oder Siliciumdioxid eingesetzt werden. Das elementare Silicium und/oder Siliciumdioxid kann grundsätzlich in allen erhältlichen Reinheitsgraden eingesetzt werden. Um die Materialkosten zu minimieren, kann beispielsweise Rohsilicium, zum Beispiel mit einem Reinheitsgrad von ≥ 95 %, eingesetzt werden.

Unter einem Ausgangswerkstoff einer Sinterverbindung kann im Rahmen der vorliegenden Erfindung ein Ausgangswerkstoff verstanden werden, welcher zur Herstellung einer Sinterverbindung, insbesondere zur mechanischen und elektrischen Verbindung von elektrischen und/oder elektronischen Komponenten, eingesetzt wird. Der erfindungsgemäße Ausgangswerkstoff kann beispielsweise eine Paste, eine Pulvermischung oder eine Sintermaterialvorformkörper, insbesondere eine Paste, sein.

Im Rahmen der vorliegenden Erfindung können als Metall insbesondere alle Elemente der Alkalimetallgruppe, insbesondere Li, Na, K, Rb, Cs, und Erdalkalimetallgruppe, insbesondere Be, Mg, Ca, Sr, Ba, die Übergangsmetallelemente, insbesondere Sc, Y, La, Ti, Zr, Hf, V, Nb, Ta, Cr, Mo, W, Mn, Re, Fe, Ru, Os, Co, Rh, Ir, Ni, Pd, Pt, Cu, Ag, Au, Zn, Cd, Hg, die Lanthanoiden sowie die Elemente Aluminium, Gallium, Indium, Zinn, Thallium, Blei und Bismut verstanden werden.

Unter Edelmetallen werden im Sinn der vorliegenden Erfindung die Elemente Silber, Gold, Platin, Palladium, Ruthenium, Rhodium, Osmium und Iridium verstanden.

Silicium wird im Rahmen der vorliegenden Erfindung als Halbmetall und nicht als Metall verstanden.

Adjektive mit der Endung -haltig, wie metallhaltig, edelmetallhaltig, silberhaltig und kupferhaltig, bedeuten im Rahmen der vorliegenden Erfindung, dass mindestens ein Element der mit der Endung -haltig versehenen Elementgruppe, beispielsweise ein oder mehrere Metalle oder ein oder mehrere Edelmetalle, beziehungsweise das mit der Endung -haltig versehene Element, beispielsweise Silber oder Kupfer, enthalten ist. Neben der elementaren Form, insbesondere der metallischen Form, der Elemente beziehungsweise des Elementes, zum Beispiel elementares, also metallisches Silber, sind damit auch Verbindungen der Elemente beziehungsweise des Elementes, zum Beispiel Silbercarbonat, Silberoxid und/oder Silbercarboxylate, umfasst.

Als metallisch kann im Rahmen der vorliegenden Erfindung insbesondere eine Form verstanden werden, in der zwischen den Atomen eines oder mehrerer Elemente metallische Bindungen vorliegen, insbesondere wobei die Atome ein Gitter mit frei beweglichen (delokalisierten) Elektronen bilden.

Im Rahmen einer Ausführungsform ist das elementare Silicium und/oder Siliciumdioxid amorphes elementares Silicium und/oder amorphes Siliciumdioxid. Amorphes elementares Silicium und/oder amorphes Siliciumdioxid weisen vorteilhafterweise einen besonders niedrigen thermischen Längenausdehnungskoeffizienten und ein niedriges Young-Modul auf, wobei insbesondere der Längenausdehnungskoeffizient und das Young-Modul von amorphem elementaren Silicium geringer als von kristallinem elementarem Silicium beziehungsweise von amorphem Siliciumdioxid geringer als von kristallinem Siliciumdioxid ist.

Im Ausgangswerkstoff für die Sinterverbindung enthalten die zweiten Partikel zumindest anteilig elementares, beispielsweise amorphes oder kristallines, insbesondere amorphes, Silicium beziehungsweise sind zumindest anteilig oder sogar vollständig daraus ausgebildet. Zum Beispiel können die zweiten Partikel Partikelkerne aufweisen, welche aus elementarem Silicium, beispielsweise amorphem oder kristallinem, insbesondere amorphem, elementarem Silicium, ausgebildet sind. Elementares Silicium wird im Rahmen der vorliegenden Erfindung bevorzugt eingesetzt, da sich sowohl dessen amorphe Form verglichen mit amorphem Siliciumdioxid als auch dessen kristalline Form verglichen mit kristallinem Siliciumdioxid durch einen geringeren Längenausdehnungskoeffizienten sowie eine höhere elektrische Leitfähigkeit und Wärmeleitfähigkeit auszeichnet. Durch den Einsatz von elementarem Silicium kann der thermische Längenausdehnungskoeffizient der Sinterverbindung daher vorteilhafterweise, insbesondere unter Aufrechterhaltung guter elastischer Eigenschaften, deutlich verringert werden.

Der D₅₀-Wert der ersten Partikel und/oder zweiten Partikel sowie der nachstehend erläuterten dritten und/oder vierten Partikel kann zum Beispiel in einem Bereich von ≥ 0,01 µm bis ≤ 50 µm, insbesondere ≥ 0,1 µm bis ≤ 10 µm, beispielsweise von ≥ 1 µm bis ≤ 7 µm, liegen. Partikel mit einer derartigen Korngrößeverteilung weisen vorteilhafterweise eine große spezifische Oberfläche und damit eine erhöhte Reaktionsfähigkeit auf. So kann vorteilhafterweise die notwendige Verarbeitungstemperatur und die Prozesszeit zur Ausbildung einer Sinterverbindung gering gehalten werden.

Unter dem D₅₀-Wert wird der Medianwert einer Teilchengrößeverteilung, insbesondere von Primärteilchen, insbesondere gemäß DIN 53 206, verstanden, welcher den Teilchendurchmesser, insbesondere Primärteilchendurchmesser, angibt, oberhalb und unterhalb dessen jeweils der Durchmesser der Hälfte der Teilchen liegt und welcher dem Durchmesser entspricht, bei dem die Summenverteilung den Wert 0,5 erreicht. Der D₅₀-Wert von Partikeln und insbesondere von Mischungen aus mehreren unterschiedlichen Partikeln, wie ersten, zweiten, dritten und/oder vierten Partikeln, kann insbesondere mittels Elektronenmikroskopie, gegebenenfalls in Kombination mit Energiedispersiver Röntgenspektroskopie (EDX), ermittelt werden.

Im Rahmen einer weiteren Ausführungsform sind die zweiten Partikel sphärische, insbesondere im Wesentlichen runde, beispielsweise im Wesentlichen kugelförmige, Partikel. Dabei kann der Begriff "im Wesentlichen" derart verstanden werden, dass leichte Abweichungen von der Idealform, insbesondere Kugelform, beispielsweise um bis zu 15 %, umfasst sein sollen. Durch eine Vermeidung von Ecken und Kanten können vorteilhafterweise Spannungsüberhöhungen und somit Risskeimstellen im Verbundmaterial vermieden werden.

Im Rahmen einer weiteren Ausführungsform weisen die ersten Partikel einen Partikelkern mit einer darauf aufgetragenen ersten Beschichtung. Immer weisen die zweiten Partikel einen Partikelkern mit einer darauf aufgetragenen zweiten Beschichtung auf.

Die erste und/oder zweite Beschichtung beziehungsweise die später erläuterte dritte und/oder vierte und/oder weitere Beschichtung umschließt dabei vorteilhafterweise jeweils die Partikelkerne im Wesentlich vollständig, zumindest jedoch nahezu vollständig. Dadurch wirken die Beschichtungen einerseits wie ein Schutzmantel, mittels welchem sichergestellt werden kann, dass die Partikel sowie der Anteil des in der jeweiligen Beschichtung enthaltenen Materials chemisch stabil bleibt, was sich vorteilhaft auf die Lagerungsfähigkeit auswirkt. Zudem kann so eine Agglomeration der Partikel verringert oder sogar vermieden werden. Weiterhin kann durch eine insbesondere metallhaltige, insbesondere metallische, Beschichtung, beispielsweise auf den zweiten, gegebenenfalls dritten und gegebenenfalls vierten Partikeln, das Ansintern der beschichteten Partikeln, beispielsweise an den ersten oder anderen Partikeln verbessert werden.

Vorzugsweise nehmen die Beschichtungen einen deutlich geringeren Anteil am Partikelvolumen als die Partikelkerne an. Dies wirkt sich vorteilhaft auf den Sinterprozess sowie die thermischen und elektrischen Eigenschaften des Ausgangswerkstoffs und der Sinterverbindung aus.

Im Rahmen einer weiteren Ausführungsform sind die ersten Partikel edelmetall- und/oder kupferhaltige. Als Edelmetall sind Silber, Gold, Platin und/oder Palladium besonders bevorzugt. Vorzugsweise sind die ersten Partikel silberhaltig.

Im Rahmen einer weiteren Ausführungsform enthalten die ersten Partikel insbesondere mindestens ein Metall, insbesondere mindestens ein Edelmetall und/oder Kupfer, vorzugsweise Silber, in metallischer Form und/oder mindestens eine organische oder anorganische Metallverbindung, insbesondere Edelmetall- und/oder Kupferverbindung, vorzugsweise Silberverbindung, insbesondere welche durch eine Temperaturbehandlung in die metallische Form des mindestens einen zugrunde liegenden Metalls umwandelbar ist. Die organische oder anorganische Metallverbindung kann beispielsweise ausgewählt sein aus der Gruppe bestehend aus Silbercarbonat, Silberoxid, Silberlactat, Silberstearat und Kombinationen davon. Diese Verbindungen können sich vorteilhafterweise bei hohen Temperaturen in das zugrunde liegende Metall in metallischer Form umwandeln.

Insbesondere können die ersten Partikel einen metallhaltigen, insbesondere edelmetall- und/oder kupferhaltigen, beispielsweise silberhaltigen, Partikelkern aufweisen.

Im Rahmen einer Ausgestaltung weist zumindest ein Teil der ersten Partikel einen Partikelkern auf, welcher mindestens ein Metall, insbesondere mindestens ein Edelmetall und/oder Kupfer, vorzugsweise Silber, in metallischer Form enthält. Beispielsweise kann zumindest ein Teil der ersten Partikel aus mindestens einem Metall, insbesondere Edelmetall und/oder Kupfer, vorzugsweise Silber, in metallischer Form ausgebildet sein.

Im Rahmen einer alternativen oder zusätzlichen Ausgestaltung weist zumindest ein Teil der ersten Partikel einen Partikelkern auf, welcher mindestens eine organische oder anorganische Metallverbindung, insbesondere Edelmetall- und/oder Kupferverbindung, vorzugsweise Silberverbindung, enthält, insbesondere welche durch eine Temperaturbehandlung in die metallische Form des mindestens einen zugrunde liegenden Metalls umwandelbar ist.

Im Rahmen einer speziellen Ausgestaltung weist zumindest ein erster Teil der ersten Partikel einen Partikelkern auf, welcher mindestens ein Metall, insbesondere mindestens ein Edelmetall und/oder Kupfer, vorzugsweise Silber, in metallischer Form enthält, wobei zumindest ein zweiter Teil der ersten Partikel einen Partikelkern aufweist, welcher mindestens eine organische oder anorganische Metallverbindung, insbesondere Edelmetall- und/oder Kupferverbindung, vorzugsweise Silberverbindung, enthält, welche durch eine Temperaturbehandlung in die metallische Form des mindestens einen Metalls des ersten Teils der ersten Partikel umwandelbar ist.

Alternativ oder zusätzlich dazu kann die erste Beschichtung, beispielsweise des ersten Teils der ersten Partikel, mindestens eine organische oder anorganische Metallverbindung, insbesondere Edelmetall- und/oder Kupferverbindung, vorzugsweise Silberverbindung, enthalten, insbesondere welche durch eine Temperaturbehandlung in das mindestens eine zugrunde liegende Metall in metallischer Form umwandelbar ist. Die organische oder anorganische Metallverbindung kann auch hierbei beispielsweise ausgewählt sein aus der Gruppe bestehend aus Silbercarbonat, Silberoxid, Silberlactat, Silberstearat und Kombinationen davon. Diese Verbindungen können sich vorteilhafterweise bei hohen Temperaturen in das zugrunde liegende Metall in metallischer Form umwandeln.

Alternativ oder zusätzlich kann die erste Beschichtung der ersten Partikel oder eine weitere, auf der ersten Beschichtung der ersten Partikel aufgebrachte Beschichtung ein Reduktionsmittel enthalten, mittels welchem die Reduktion einer beziehungsweise der organischen oder anorganischen Metallverbindung, insbesondere Edelmetall- und/oder Kupferverbindung, vorzugsweise Silberverbindung, zur metallischen Form, beispielsweise bei einer Temperatur im Bereich der oder gegebenenfalls unterhalb der Sintertemperatur der metallischen Form des mindestens einen zugrunde liegenden Metals, durchführbar ist.

Alternativ oder zusätzlich dazu können auch die zweiten, dritten und/oder vierten Partikel eine derartige Reduktionsmittel enthaltende Beschichtung aufweisen.

Der Reduktionsmittelanteil des Ausgangswerkstoffs wird vorzugsweise derart gewählt, dass dieser in einem stöchiometrischen Verhältnis zu dem Anteil der in dem Ausgangswerkstoff enthaltenen, insbesondere zu reduzierenden, organischen oder anorganischen Metallverbindung, insbesondere Edelmetall- und/oder Kupferverbindung, vorzugsweise Silberverbindung, vorliegt. So kann vorteilhafterweise eine sehr hohe Umwandlungsquote von bis zu 99 % oder mehr erzielt werden.

Als Reduktionsmittel kann beispielsweise mindestens ein Alkohol aus der Gruppe der primären oder sekundären Alkohole und/oder mindestens ein Amin und/oder Ameisensäure und/oder mindestens eine Fettsäure, insbesondere Isostearinsäure, Stearinsäure, Ölsäure, Laurinsäure oder eine Mischung verschiedener Fettsäuren, eingesetzt werden.

Insgesamt lassen sich derartige reduktionsmittelhaltige erste Beschichtungen in einfacher Weise auf die ersten Partikeln aufbringen. Durch Reduktionsmittel enthaltende Beschichtungen kann das Reduktionsmittel vorteilhafterweise insgesamt im Ausgangswerkstoff sehr gleichmäßig und fein verteilt werden. Dadurch kann der Sinterprozess innerhalb des Ausgangswerkstoffes einheitlicher und schneller erfolgen. Daraus resultiert der Vorteil, dass eine aus dem erfindungsgemäßen Ausgangswerkstoff hergestellte Sinterverbindung ein sehr homogenes Sintergefüge, insbesondere mit einer hohen thermischen und/oder elektrischen Leitfähigkeit, aufweisen kann. Dieser Effekt kann durch den Einsatz von Beschichtungen, welche zu den ersten Partikeln korrespondierende organischen oder anorganischen Metallverbindungen, insbesondere Edelmetall- und/oder Kupferverbindungen, vorzugsweise Silberverbindungen, enthalten und beispielsweise in direktem Kontakt mit den Reduktionsmittel enthaltenden Beschichtungen stehen, noch verstärkt werden. Vorteilhafterweise kann dabei die Temperatur, bei der sich die organische oder anorganische Metallverbindung in die zugrunde liegende metallische Form umwandelt, gesenkt werden. Dadurch ist es möglich, dass in vorteilhafter Weise über die ausgebildete Sinterverbindung verbundene Fügepartner, beispielsweise elektrische und/oder elektronische Komponenten einer elektronischen Schaltung, keinen hohen Temperaturen während der Ausbildung der Sinterverbindung ausgesetzt werden. Somit können temperaturempfindliche elektrische und/oder elektronische Komponenten in elektronischen Schaltungen elektrisch und/oder thermisch kontaktiert werden, die auf Grund der sonst üblichen zu hohen Prozesstemperaturen bei der Verbindungsherstellung nicht eingesetzt werden konnten.

Im Rahmen einer weiteren Ausführungsform weisen die zweiten Partikel einen Partikelkern aus elementarem Silicium und/oder Siliciumdioxid, beispielsweise amorphem elementarem Silicium und/oder Siliciumdioxid, insbesondere Silicium, auf.

Anders als die Erfindung enthält in einer anderen Ausgestaltung die zweite Beschichtung mindestens ein Metall als eine organische oder anorganische Metallverbindung, insbesondere Edelmetall- und/oder Kupferverbindung, vorzugsweise Silberverbindung, insbesondere welche durch eine Temperaturbehandlung in die metallische Form, insbesondere des mindestens einen zugrunde liegenden Metals, insbesondere der ersten Partikel, umwandelbar ist.

Grundsätzlich enthält die zweite Beschichtung mindestens ein Metall, welches ausgewählt ist aus der Gruppe bestehend aus Silber, Platin, Palladium, Gold, Zinn und Kombinationen davon. Insbesondere kann die zweite Beschichtung die gleichen Metalle wie die ersten Partikel, zum Beispiel Silber, enthalten. So kann vorteilhafterweise die Haftung der zweiten Partikel in dem Ausgangswerkstoff verbessert werden. Da die Schichtdicke der Beschichtung vorzugsweise kleiner als der Radius der Partikelkerne ist, beeinflusst deren thermischer Längenausdehnungskoeffizient den der Sinterverbindung weniger als der Längenausdehnungskoeffizient des Partikelkernmaterials. Um den Längenausdehnungskoeffizienten des Sintermaterials weiter zu minimieren kann es jedoch vorteilhaft sein, Platin und/oder Palladium im Beschichtungsmaterial einzusetzen.

Im Rahmen einer weiteren Ausführungsform umfasst der Ausgangswerkstoff weiterhin dritte Partikel. Auch die dritten Partikel können einen Partikelkern und gegebenenfalls eine auf den Partikelkern aufgetragene dritte Beschichtung aufweisen. Vorzugsweise enthalten die dritten Partikel zumindest anteilig ein, insbesondere chemisch inertes und physikalisch stabiles, Partikelkernmaterial. Zum Beispiel können die dritten Partikel oder zumindest deren Partikelkerne dabei aus einem chemisch inerten und physikalisch stabilen Material ausgebildet sein,

Unter einem chemisch inerten Material wird dabei ein Material verstanden, welches unter den Sinterbedingungen keine chemische Reaktion mit den übrigen Materialien des Ausgangswerkstoffs eingeht.

Unter einem physikalisch stabilen Material wird dabei ein Material verstanden, welches unter den Sinterbedingungen keinen Phasenübergang, beispielsweise von fest nach flüssig (Schmelzen), aufweist.

Im Rahmen einer weiteren Ausführungsform weist das Partikelkernmaterial der dritten Partikel bei 20 °C einen geringeren thermischen Längenausdehnungskoeffizienten α als das oder die Metalle der ersten Partikel in metallischer Form auf.

Im Rahmen einer weiteren Ausführungsform weist das Partikelkernmaterial der dritten Partikel bei 20 °C einen thermischen Längenausdehnungskoeffizienten α von ≤ 15 10⁻⁶K⁻¹, insbesondere von ≤ 10 10⁻⁶K⁻¹ oder von ≤ 7,5 10⁻⁶K⁻¹, vorzugsweise von ≤ 5 10⁻⁶K⁻¹, auf. Insbesondere können die dritten Partikel beziehungsweise zumindest deren Partikelkerne aus einem derartigen Material ausgebildet sein.

Im Rahmen einer weiteren Ausführungsform weist das Partikelkernmaterial der dritten Partikel bei 20 °C und 50 % Luftfeuchte eine Wärmeleitfähigkeit λ_{20/50} von ≥ 15 Wm⁻¹K⁻¹ oder ≥ 25 Wm⁻¹K⁻¹, vorzugsweise von ≥ 50 Wm⁻¹K⁻¹, insbesondere von ≥ 100 Wm⁻¹K⁻¹, auf. Insbesondere können die dritten Partikel beziehungsweise zumindest deren Partikelkerne aus einem derartigen Material ausgebildet sein. Dies ist insbesondere zur Steigerung der Leistungsdichte von Halbleiterchips vorteilhaft.

Im Rahmen einer weiteren Ausführungsform ist das Partikelkernmaterial der dritten Partikel ein, insbesondere keramisches oder metallisches, Material, welches ausgewählt ist aus der Gruppe bestehend aus Siliciumcarbid (SiC), Aluminiumnitrid (AlN), Siliciumnitrid (Si₃N₄), Aluminiumoxid (Al₂O₃), metallischem Wolfram (W), metallischem Molybdän (Mo), metallischem Chrom (Cr), Borcarbid (BC), Berylliumoxid (BeO), Bornitrid (BN), vorzugsweise Siliciumcarbid (SiC), Aluminiumnitrid (AIN), Siliciumnitrid (Si₃N₄), Aluminiumoxid (Al₂O₃), sowie Kombinationen davon. Insbesondere kann das Partikelkernmaterial ausgewählt sein aus der Gruppe bestehend aus Siliciumcarbid (SiC), Aluminiumnitrid (AIN), Siliciumnitrid (Si₃N₄), Aluminiumoxid (Al₂O₃), metallischem Wolfram (W), metallischem Molybdän (Mo), metallischem Chrom (Cr), Borcarbid (BC), Berylliumoxid (BeO), Bornitrid (BN) sowie Kombinationen davon. Insbesondere können die dritten Partikel beziehungsweise zumindest deren Partikelkerne aus einem derartigen Material ausgebildet sein. Siliciumcarbid (SiC), Aluminiumnitrid (AIN), Siliciumnitrid (Si₃N₄), Aluminiumoxid (Al₂O₃), metallisches Wolfram (W), metallisches Molybdän (Mo), metallisches Chrom (Cr), Borcarbid (BC), Berylliumoxid (BeO), Bornitrid (BN), insbesondere Siliciumcarbid (SiC), Aluminiumnitrid (AIN), Siliciumnitrid (Si₃N₄) und Aluminiumoxid (Al₂O₃) weisen vorteilhafterweise einen geringen thermischen Längenausdehnungskoeffizienten auf, was wie bereits erläutert vorteilhaft ist um eine Rissbildung der Fügepartner zu vermeiden.

Die dritte Beschichtung kann metallhaltig, insbesondere edelmetall- und/oder kupferhaltig, vorzugsweise silberhaltig, sein. Im Rahmen einer Ausgestaltung enthält die dritte Beschichtung mindestens ein Metall, insbesondere Edelmetall- und/oder Kupfer, vorzugsweise Silber, in metallischer Form. Im Rahmen einer anderen Ausgestaltung enthält die dritte Beschichtung mindestens ein Metall als eine organische oder anorganische Metallverbindung, insbesondere Edelmetall- und/oder Kupferverbindung, vorzugsweise Silberverbindung, insbesondere welche durch eine Temperaturbehandlung in die metallische Form des mindestens einen zugrunde liegenden Metalls, insbesondere der ersten Partikel, umwandelbar ist. Die organische oder anorganische Metallverbindung kann auch hierbei beispielsweise ausgewählt sein aus der Gruppe bestehend aus Silbercarbonat, Silberoxid, Silberlactat, Silberstearat und Kombinationen davon. Diese Verbindungen können sich vorteilhafterweise bei hohen Temperaturen in das zugrunde liegende Metall in metallischer Form umwandeln.

Alternativ oder zusätzlich kann die dritte Beschichtung oder eine weitere, auf der dritten Beschichtung aufgebrachte Beschichtung ein Reduktionsmittel enthalten, mittels welchem die Reduktion einer beziehungsweise der organischen oder anorganischen Metallverbindung insbesondere Edelmetall- und/oder Kupferverbindung, vorzugsweise Silberverbindung, insbesondere des/der Metalls/Metalle der ersten Partikel, zur metallischen Form, beispielsweise bei einer Temperatur im Bereich der oder gegebenenfalls unterhalb der Sintertemperatur der metallischen Form des mindestens einen zugrunde liegenden Metalls, insbesondere der ersten Partikel, durchführbar ist.

Im Rahmen einer weiteren Ausführungsform enthält die dritte Beschichtung mindestens ein Metall, welches ausgewählt ist aus der Gruppe bestehend aus Silber, Platin, Palladium, Gold, Zinn und Kombinationen davon. Vorzugsweise enthält die dritte Beschichtung zumindest eines der Metalle der ersten Partikel. Insbesondere kann die dritte Beschichtung die gleichen Metalle wie die ersten Partikel, zum Beispiel Silber, enthalten. So kann vorteilhafterweise die Haftung der dritten Partikel in dem Ausgangswerkstoff verbessert werden. Da die Schichtdicke der Beschichtung vorzugsweise kleiner als der Radius der Partikelkerne ist, beeinflusst deren thermischer Längenausdehnungskoeffizient den der Sinterverbindung weniger als der Längenausdehnungskoeffizient des Partikelkernmaterials. Um den Längenausdehnungskoeffizienten des Sintermaterials weiter zu minimieren kann es jedoch vorteilhaft sein, Platin und/oder Palladium im Beschichtungsmaterial einzusetzen.

Weiterhin kann der Ausgangswerkstoff vierte Partikel umfassen. Auch die vierten Partikel können einen Partikelkern und gegebenenfalls eine auf den Partikelkern aufgetragene vierte Beschichtung aufweisen. Die vierte Beschichtung kann metallhaltig, insbesondere edelmetall- und/oder kupferhaltig, vorzugsweise silberhaltig, sein. Im Rahmen einer Ausgestaltung enthält die vierte Beschichtung mindestens ein Metall, insbesondere Edelmetall- und/oder Kupfer, vorzugsweise Silber, in metallischer Form. Im Rahmen einer anderen Ausgestaltung enthält die vierte Beschichtung mindestens ein Metall als eine organische oder anorganische Metallverbindung, insbesondere Edelmetall- und/oder Kupferverbindung, vorzugsweise Silberverbindung, insbesondere welche durch eine Temperaturbehandlung in die metallische Form des mindestens einen zugrunde liegenden Metalls, insbesondere der ersten Partikel, umwandelbar ist. Die organische oder anorganische Metallverbindung kann auch hierbei beispielsweise ausgewählt sein aus der Gruppe bestehend aus Silbercarbonat, Silberoxid, Silberlactat, Silberstearat und Kombinationen davon. Diese Verbindungen können sich vorteilhafterweise bei hohen Temperaturen in das zugrunde liegende Metall in metallischer Form umwandeln.

Alternativ oder zusätzlich kann die vierte Beschichtung oder eine weitere, auf der vierten Beschichtung aufgebrachte Beschichtung ein Reduktionsmittel enthalten, mittels welchem die Reduktion einer beziehungsweise der organischen oder anorganischen Metallverbindung insbesondere Edelmetall- und/oder Kupferverbindung, vorzugsweise Silberverbindung, insbesondere des/der Metalls/Metalle der ersten Partikel, zur metallischen Form, beispielsweise bei einer Temperatur im Bereich der oder gegebenenfalls unterhalb der Sintertemperatur der metallischen Form des mindestens einen zugrunde liegenden Metalls, insbesondere der ersten Partikel, durchführbar ist.

Im Rahmen einer weiteren Ausführungsform enthält die vierte Beschichtung mindestens ein Metall, welches ausgewählt ist aus der Gruppe bestehend aus Silber, Platin, Palladium, Gold und Kombinationen davon. Vorzugsweise enthält die vierte Beschichtung zumindest eines der Metalle der ersten Partikel. Insbesondere kann die vierte Beschichtung die gleichen Metalle wie die ersten Partikel, zum Beispiel Silber, enthalten. So kann vorteilhafterweise die Haftung der vierten Partikel in dem Ausgangswerkstoff verbessert werden. Da die Schichtdicke der Beschichtung vorzugsweise kleiner als der Radius der Partikelkerne ist, beeinflusst deren thermischer Längenausdehnungskoeffizient den der Sinterverbindung weniger als der Längenausdehnungskoeffizient des Partikelkernmaterials. Um den Längenausdehnungskoeffizienten des Sintermaterials weiter zu minimieren kann es jedoch vorteilhaft sein, Platin und/oder Palladium im Beschichtungsmaterial einzusetzen.

Vorzugsweise enthalten die vierten Partikel oder zumindest deren Partikelkerne mindestens ein Metall, beispielsweise Zinn, insbesondere in metallischer Form, welches durch eine Temperaturbehandlung, beispielsweise im Bereich der oder gegebenenfalls unterhalb der Sintertemperatur der metallischen Form des/der Metalls/Metalle der ersten Partikel, eine Legierung mit dem oder den Metallen der ersten Partikel ausbildet, insbesondere welche einen niedrigeren Schmelzpunkt aufweist als das oder die Metalle der ersten Partikel in metallischer Form. So kann vorteilhafterweise die Verarbeitungstemperatur zur Ausbildung der Sinterverbindung weiter gesenkt werden kann. Ferner können die Legierungen als duktile Phasen innerhalb des gebildeten Sintergefüges vorliegen, wodurch die gebildeten Sinterverbindungen weniger anfällig gegenüber thermischen und/oder mechanischen Belastungen, insbesondere wechselnden Belastungen sind. Ferner weist beispielsweise Zinn einen niedrigen Schmelzpunkt auf, sodass bei einer Temperaturbehandlung des Ausgangswerkstoffes die Partikel aus Zinn frühzeitig aufschmelzen und einen stoffschlüssigen Kontakt aller im Ausgangswerkstoff enthaltenen Partikel bewirken. Dies begünstigt in vorteilhafter Weise die während des Sinterprozesses ablaufenden Diffusionsvorgänge.

Im Rahmen einer weiteren Ausführungsform umfasst der Ausgangswerkstoff, bezogen auf das Gesamtgewicht der Bestandteile, ≥ 5 Gew.-%, insbesondere ≥ 10 Gew.-%, beispielsweise ≥ 20 Gew.-% oder ≥ 25 Gew.-%, an zweiten Partikeln, insbesondere wobei die Summe der Bestandteile des Ausgangswerkstoffs 100 Gew.-% ergibt. Mit einer derartigen Menge an zweiten Partikeln kann eine deutliche Verringerung des thermischen Längenausdehnungskoeffizienten der Sinterverbindung, insbesondere bezogen auf eine entsprechende Sinterverbindung, welche anstelle der zweiten Partikel einen weiteren Teil erste Partikel umfasst, erzielt werden.

Im Rahmen einer weiteren Ausführungsform umfasst der Ausgangswerkstoff, bezogen auf das Gesamtgewicht der Bestandteile, ≤ 60 Gew.-%, insbesondere ≤ 50 Gew.-%, an zweiten Partikeln, insbesondere wobei die Summe der Bestandteile des Ausgangswerkstoffs 100 Gew.-% ergibt. Mit einer derartigen Menge an zweiten Partikeln im Ausgangswerkstoff kann vorteilhafterweise noch eine gut anbindende beziehungsweise haftende Sinterschicht erzeugt werden.

Insofern der Ausgangswerkstoff weiterhin noch dritte und/oder vierte Partikel aufweist, umfasst der Ausgangswerkstoff, bezogen auf das Gesamtgewicht der Bestandteile, an zweiten und dritten und/oder vierten Partikeln in Summe ≤ 60 Gew.-%, insbesondere ≤ 50 Gew.-%, insbesondere wobei die Summe der Bestandteile des Ausgangswerkstoffs 100 Gew.-% ergibt.

Im Rahmen einer weiteren Ausführungsform umfasst der Ausgangswerkstoff, bezogen auf das Gesamtgewicht der Bestandteile, ≥ 5 Gew.-% oder ≥ 10 Gew.-% bis ≤ 60 Gew.-%, insbesondere ≥ 10 Gew.-% oder ≥ 20 Gew.-% oder ≥ 25 Gew.-% bis ≤ 50 Gew.-%, an zweiten Partikeln beziehungsweise an zweiten und dritten und/oder vierten Partikeln in Summe, insbesondere wobei die Summe der Bestandteile des Ausgangswerkstoffs 100 Gew.-% ergibt.

Im Rahmen einer weiteren Ausführungsform umfasst der Ausgangswerkstoff, bezogen auf das Gesamtgewicht der Bestandteile, ≥ 25 Gew.-% bis ≤ 80 Gew.-% an ersten Partikeln, insbesondere wobei die Summe der Bestandteile des Ausgangswerkstoffs 100 Gew.-% ergibt.

Weiterhin kann der Ausgangswerkstoff mindestens ein Lösungsmittel umfassen. Zum Beispiel kann der Ausgangswerkstoff, bezogen auf das Gesamtgewicht der Bestandteile, ≥ 5 Gew.-% oder ≥ 10 Gew.-% bis ≤ 25 Gew.-%, insbesondere ≥ 10 Gew.-% bis ≤ 20 Gew.-%, an Lösungsmitteln umfassen, insbesondere wobei die Summe der Bestandteile des Ausgangswerkstoffs 100 Gew.-% ergibt.

Weiterhin kann der Ausgangswerkstoff einen oder mehrere Zusatzstoffe, beispielsweise Reduktions- und/oder Oxidationsmittel, umfassen.

Zum Beispiel kann der Ausgangswerkstoff ≥ 25 Gew.-% bis ≤ 80 Gew.-% an ersten Partikeln und ≥ 5 Gew.-% bis ≤ 60 Gew.-% an zweiten Partikeln beziehungsweise an zweiten und dritten und/oder vierten Partikeln in Summe umfassen, insbesondere wobei die Summe der Bestandteile des Ausgangswerkstoffs 100 Gew.-% ergibt. Weiterhin kann der Ausgangswerkstoff ≥ 5 Gew.-% bis ≤ 25 Gew.-% an Lösungsmitteln und/oder ≥ 0,1 Gew.-% bis ≤ 10 Gew.-% an Zusatzstoffen umfassen, insbesondere wobei die Summe der Bestandteile des Ausgangswerkstoffs 100 Gew.-% ergibt.

Der Ausgangswerkstoff wird vorzugsweise als Paste bereitgestellt. Die Viskosität der Paste ist dabei maßgeblich durch das beigemischte Lösungsmittel einstellbar. Ebenso ist es von Vorteil, den Ausgangswerkstoff in Form einer Tablette oder als Formkörper, insbesondere als flachen Formkörper, bereitzustellen. In diesem Fall wird der pastenförmige Ausgangswerkstoff in eine Form gegeben oder auf eine Folie aufgetragen. Anschließend wird das Lösungsmittel mittels einer Temperaturbehandlung aus dem Ausgangswerkstoff ausgetrieben. Hier kann insbesondere ein Lösungsmittel vorgesehen werden, welches bereits bei einer Temperatur im Bereich der oder unterhalb der Sintertemperatur des Ausgangswerkstoffs rückstandsfrei ausgetrieben werden kann. Der auf diese Weise gebildete Ausgangswerkstoff kann auch als Großnutzen gefertigt werden, welcher dann zu kleinen anwendungsspezifischen Formkörpern geschnitten wird.

Grundsätzlich können die erste, die zweite, die dritte, die vierte und die weiteren Beschichtungen der im Ausgangswerkstoff enthaltenen ersten, zweiten, dritte und/oder vierten Partikeln mit Hilfe bekannter Beschichtungsverfahren ausgeführt werden. Diese können aus bekannter technischer Literatur entnommen werden. Beispielhaft sind hierbei chemische und physikalische Beschichtungsverfahren zu nennen, wie zum Beispiel eine chemische bzw. physikalische Gasphasenabscheidung.

Hinsichtlich weiterer Merkmale und Vorteile des erfindungsgemäßen Ausgangswerkstoffs wird hiermit explizit auf die Erläuterungen im Zusammenhang mit der Verwendung, der Sinterverbindung, der elektronischen Schaltung, dem Verfahren sowie den Figuren verwiesen.

Bereits bekannt ist die Verwendung von elementarem Silicium und/oder Siliciumdioxid zur Verringerung des thermischen Längenausdehnungskoeffizienten α eines Ausgangswerkstoffs einer Sinterverbindung beziehungsweise einer Sinterverbindung, insbesondere in einer Sinterpaste, einem Sinterpulver oder einem Sintermaterialvorformkörper.

Ermöglicht ist daher eine Sinterverbindung aus einem Ausgangswerkstoff, welcher metallhaltige, insbesondere edelmetall- und/oder kupferhaltige, beispielsweise silberhaltige, erste Partikel sowie zweite und/oder dritte Partikel umfasst, wobei die zweiten Partikel zumindest anteilig elementares Silicium und/oder Siliciumdioxid enthalten und/oder wobei die dritten Partikel zumindest anteilig ein, insbesondere chemisch inertes und physikalisch stabiles, Material, beispielsweise Siliciumcarbid, Aluminiumnitrid, Siliciumnitrid, Aluminiumoxid, metallisches Wolfram, metallisches Molybdän, metallisches Chrom, Borcarbid, Berylliumoxid und/oder Bornitrid, enthalten, insbesondere dessen thermischer Längenausdehnungskoeffizient α bei 20 °C geringer als der thermische Längenausdehnungskoeffizient α bei 20 °C des Metalls beziehungsweise der Metalle der ersten Partikel in metallischer Form und/oder dessen thermischer Längenausdehnungskoeffizient α bei 20 °C ≤ 15·10⁻⁶K⁻¹, beispielsweise ≤ 10 10⁻⁶K⁻¹ oder ≤ 7,5·10⁻⁶K⁻¹, vorzugsweise ≤ 5·10⁻⁶K⁻¹ ist.

Bisherige Versuche zeigen, dass eine aus einem derartigen Ausgangswerkstoff gebildete Sinterverbindung vorteilhafterweise einen thermischen Längenausdehnungskoeffizienten α bei 20 °C in einem Bereich von ≥ 3·10⁻⁶ K⁻¹ bis ≤ 15·10⁻⁶ K⁻¹, beispielsweise ≥ 3·10⁻⁶ K⁻¹ bis ≤ 10·10⁻⁶ K⁻¹, insbesondere von ≥ 3·10⁻⁶ K⁻¹ bis ≤ 7·10⁻⁶ K⁻¹ aufweisen kann. Sinterverbindungen mit einem derartig niedrigen thermischen Längenausdehnungskoeffizienten können durch die herkömmlicherweise eingesetzten Silbersinterpasten, welche üblicherweise einen thermischen Längenausdehnungskoeffizienten α bei 20 °C um 19,5·10⁻⁶K⁻¹ aufweisen, nicht erreicht werden und sind insbesondere für die Halbleitertechnik von besonderem Interesse, da hierbei häufig Fügepartner mittels Sinterverbindungen zusammengefügt werden, welche einerseits, wie Chips, einen sehr niedrigen Längenausdehnungskoeffizienten, zum Beispiel von etwa 3·10⁻⁶ K⁻¹, und andererseits, beispielsweise metallische Schaltungsträger, einen sehr hohen Längenausdehnungskoeffizienten, zum Beispiel von etwa 16,5·10⁻⁶ K⁻¹, aufweisen, was eine der Hauptursachen für die Rissbildung bei Temperaturwechselbeanspruchung ist. Durch die zweiten und/oder dritten Partikel kann der thermische Längenausdehnungskoeffizient vorteilhafterweise derart eingestellt werden, dass dieser zwischen den thermischen Längenausdehnungskoeffizienten der über die Sinterschicht zu verbindenden Fügepartnern, beispielsweise zwischen 16,5·10⁻⁶ K⁻¹ (Schaltungsträger) und 3·10⁻⁶ K⁻¹ (Chip) liegt. So können thermomechanische Spannungen zwischen den Fügepartner und der Sinterverbindung, welche bei Temperaturwechselbeanspruchung zur Rissbildung in den Fügepartnern führen kann, vorteilhafterweise deutlich reduziert werden. Die aus dem erfindungsgemäßen Ausgangswerkstoff gebildete Sinterverbindung kann zudem vorteilhafterweise eine verhältnismäßig hohe Wärmeleitfähigkeit, gemessen bei 20 °C und 50 % Luftfeuchte, von ≥ 100 Wm⁻¹K⁻¹ aufweisen. Dies ist insbesondere zur Steigerung der Leistungsdichte von Halbleiterchips vorteilhaft. Insbesondere durch den Zusatz von elementarem Silizium kann der Rissbildung gut entgegen getreten werden, da sich elementares Silicium aufgrund seines niedrigen Young-Moduls besonders vorteilhaft auf die Elastizität der Sinterverbindung auswirkt. Zudem können die erfindungsgemäßen Sinterverbindungen vorteilhafterweise eine elektrische Leitfähigkeit erreichen, welche nur gering unter der von reinem Silber liegt.

Vorzugsweise wird der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, derart eingestellt, dass der thermische Längenausdehnungskoeffizient α_{S} der Sinterverbindungsschicht bei 20 °C kleiner oder gleich dem thermischen Längenausdehnungskoeffizienten α_{F1} eines ersten (mittels der Sinterverbindung verbundenen) Fügepartners bei 20 °C und größer oder gleich dem thermischen Längenausdehnungskoeffizienten α_{F2} eines zweiten (mittels der Sinterverbindung verbundenen) Fügepartners bei 20 °C ist.

Im Rahmen einer Ausgestaltung wird der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, in dem Ausgangswerkstoff derart eingestellt, dass der thermische Längenausdehnungskoeffizient α_{S} der Sinterverbindung beziehungsweise des mittleren Bereichs der Sinterverbindung in einem Bereich: α_{F2}+0,2·(α_{F1}-α_{F2}) ≤ α_{S} ≤ α_{F2}+0,8·(α_{F1}- α_{F2}), insbesondere α_{F2}+0,25·(α_{F1}-α_{F2}) ≤ α_{S} ≤ α_{F2}+0,75·(α_{F1}- α_{F2}), liegt, wobei α_{F1} der Längenausdehnungskoeffizient eines ersten Fügepartners und α_{F2} der Längenausdehnungskoeffizient eines zweiten Fügepartners und α_{F1} ≥ α_{F2} ist. So kann vorteilhafterweise die Rissbildung unter Temperaturwechselbeanspruchung deutlich gesenkt werden.

Im Rahmen einer bevorzugten Ausgestaltung steigt der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, in der Sinterverbindung schrittweise oder kontinuierlich von einer Grenzschicht mit einem ersten Fügepartner mit einem größeren Längenausdehnungskoeffizienten in Richtung auf eine Grenzschicht mit einem zweiten Fügepartner mit einem kleineren thermischen Längenausdehnungskoeffizienten, oder umgekehrt sinkt der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, in der Sinterverbindung schrittweise oder kontinuierlich von einer Grenzschicht mit einem ersten Fügepartner mit einem kleineren Längenausdehnungskoeffizienten in Richtung auf eine Grenzschicht mit einem Fügepartner mit einem größeren thermischen Längenausdehnungskoeffizienten. So können vorteilhafterweise die Unterschiede zwischen den thermischen Längenausdehnungskoeffizienten zwischen einander kontaktierenden Grenzschichten und damit die Rissbildung unter Temperaturwechselbeanspruchung besonders vorteilhaft minimiert werden. Ein derartiger Gradient kann beispielsweise durch das Aufbringen mehrerer Sinterpastenschichten mit sinkendem beziehungsweise steigendem Anteil an zweiten und/oder dritten Partikeln, beispielsweise durch ein Druckverfahren, hergestellt werden.

Ermöglicht ist weiterhin auch ein Verfahren zur Ausbildung einer thermisch und/oder elektrisch leitenden Sinterverbindung. Ausgegangen wird hierbei von einem Ausgangswerkstoff der vorbeschriebenen Arten.

Der Ausgangswerkstoff kann hierbei zwischen zwei Fügepartner gebracht werden. Bevorzugte Fügepartner sind elektrische und/oder elektronische Komponenten mit Kontaktstellen, die in unmittelbaren physischen Kontakt mit dem Ausgangswerkstoff gebracht werden.

Der Ausgangswerkstoff umfasst insbesondere metallhaltige, insbesondere edelmetall- und/oder kupferhaltige, beispielsweise silberhaltige, erste Partikel sowie zweite und/oder dritte Partikel. Dabei enthalten die zweiten Partikel zumindest anteilig elementares Silicium und/oder Siliciumdioxid. Die dritten Partikel enthalten insbesondere zumindest anteilig ein, vorzugsweise chemisch inertes und physikalisch stabiles, Material, beispielsweise Siliciumcarbid, Aluminiumnitrid, Siliciumnitrid, Aluminiumoxid, metallisches Wolfram, metallisches Molybdän, metallisches Chrom, Borcarbid, Berylliumoxid und/oder Bornitrid, insbesondere dessen thermischer Längenausdehnungskoeffizient α bei 20 °C geringer als der thermische Längenausdehnungskoeffizient α bei 20 °C des Metalls beziehungsweise der Metalle der ersten Partikel in metallischer Form und/oder dessen thermischer Längenausdehnungskoeffizient α bei 20 °C ≤ 15·10⁻⁶K⁻¹, beispielsweise ≤ 10 10⁻⁶K⁻¹ oder ≤ 7,5·10⁻⁶K⁻¹, vorzugsweise ≤ 5·10⁻⁶K⁻¹ ist.

Vorzugsweise wird der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, derart eingestellt, dass der thermische Längenausdehnungskoeffizient αS der Sinterverbindungsschicht bei 20 °C kleiner oder gleich dem thermischen Längenausdehnungskoeffizienten α_{F1} eines ersten Fügepartners bei 20 °C und größer oder gleich dem thermischen Längenausdehnungskoeffizienten α_{F2} eines zweiten Fügepartners bei 20 °C ist.

Im Rahmen einer Ausgestaltung wird der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, derart eingestellt, dass der thermische Längenausdehnungskoeffizient α_{S} der Sinterverbindung beziehungsweise des mittleren Bereichs der Sinterverbindung in einem Bereich: α_{F2}+0,2·(α_{F1}- α_{F2}) ≤ α_{S} ≤ α_{F2}+0,8·(α_{F1}- α_{F2}), insbesondere α_{F2}+0,25·(α_{F1}- α_{F2}) ≤ α_{S} ≤ α_{F2}+0,75·(α_{F1}- α_{F2}), liegt, wobei α_{F1} der Längenausdehnungskoeffizient eines ersten Fügepartners und α_{F2} der Längenausdehnungskoeffizient eines zweiten Fügepartners und α_{F1} ≥ α_{F2} ist. So kann vorteilhafterweise die Rissbildung unter Temperaturwechselbeanspruchung deutlich gesenkt werden.

Im Rahmen einer bevorzugten Ausgestaltung steigt der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, in der Sinterverbindung schrittweise oder kontinuierlich von einer Grenzschicht mit einem ersten Fügepartner mit einem größeren Längenausdehnungskoeffizienten in Richtung auf eine Grenzschicht mit einem zweiten Fügepartner mit einem kleineren thermischen Längenausdehnungskoeffizienten, oder umgekehrt sinkt der Anteil an zweiten und/oder dritten Partikeln, insbesondere an elementarem Silicium und/oder Siliciumdioxid und/oder an Siliciumcarbid, Aluminiumnitrid, Siliciumnitrid, Aluminiumoxid, metallischem Wolfram, metallischem Molybdän, metallischem Chrom, Borcarbid, Berylliumoxid und/oder Bornitrid, in der Sinterverbindung schrittweise oder kontinuierlich von einer Grenzschicht mit einem ersten Fügepartner mit einem kleineren Längenausdehnungskoeffizienten in Richtung auf eine Grenzschicht mit einem Fügepartner mit einem größeren thermischen Längenausdehnungskoeffizienten. So können vorteilhafterweise die Unterschiede zwischen den thermischen Längenausdehnungskoeffizienten zwischen einander kontaktierenden Grenzschichten und damit die Rissbildung unter Temperaturwechselbeanspruchung besonders vorteilhaft minimiert werden.

Ein derartiger Gradient kann beispielsweise durch das Aufbringen mehrerer Sinterpastenschichten mit sinkendem beziehungsweise steigendem Anteil an zweiten und/oder dritten Partikeln, beispielsweise durch ein Druckverfahren, hergestellt werden. Hierbei kann der Ausgangswerkstoff in Form einer Druckpaste beispielsweise mittels Sieb- oder Schablonendruck auf die Kontaktstellen aufgetragen werden. Ebenso ist der Auftrag durch Injekt- oder Dispensverfahren möglich.

Eine weitere Möglichkeit besteht weiterhin, den Ausgangswerkstoff als Formkörper zwischen den Fügepartner anzuordnen.

Anschließend wird die Sinterverbindung durch eine Temperaturbehandlung des Ausgangswerkstoffes ausgebildet.

Beispielsweise kann eine Verarbeitungstemperatur von ≤ 400 °C, bevorzugt von ≤ 300 °C, insbesondere von ≤ 250 °C, vorgesehen werden. Gegebenenfalls wird zur Verbesserung des Sintervorgangs dieser unter Druck ausgeführt. Als Prozessdruck wird ein Druck ≤ 10 MPa vorgesehen, bevorzugt ≤ 4 MPa oder sogar ≤ 1,6 MPa, besonders bevorzugt ≤ 0,8 MPa. Insofern das Reduktionsmittel nicht stöchiometrisch, sondern im Überschuss eingesetzt wurde, kann überschüssiges Reduktionsmittel unter der Voraussetzung einer ausreichenden Sauerstoffzufuhr, beispielsweise unter Luftatmosphäre, vollkommen ausgebrannt werden. Bevorzugt sind Fügepartner mit Kontaktstellen aus einem Edelmetall vorgesehen, beispielsweise aus Gold, Silber oder einer Legierung aus Gold oder Silber.

Bei einer alternativen Möglichkeit eines Verfahrens wird die Sinterverbindung im Vakuum und/oder unter einer Stickstoffatmosphäre ausgebildet. Da in diesem Fall überschüssiges Reduktionsmittel nicht verbrannt werden kann, ist ein Ausgangswerkstoff vorzusehen, bei welchem der Anteil der in dem Ausgangswerkstoff enthaltenen, insbesondere zu reduzierenden, organischen oder anorganischen Metallverbindung zum Anteil des Reduktionsmittels im Ausgangswerkstoff in einem stöchiometrischen Verhältnis vorliegt. Während der Temperaturbehandlung wird das Reduktionsmittel demzufolge vollkommen aufgebraucht. Zusätzlich wird die organische oder anorganische Metallverbindung vollständig in die metallische Form umgewandelt. In vorteilhafter Weise können bei dieser Verfahrensalternative auch Fügepartner mit einer nicht edelmetallhaltigen Kontaktstelle vorgesehen werden, die beispielsweise aus Kupfer ausgebildet ist. Somit können auch kostengünstige elektrische und oder elektronische Komponenten herangezogen werden.

### Zeichnungen und Beispiele

Weitere Vorteile und vorteilhafte Ausgestaltungen der Erfindung werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen
- Fig. 1: eine schematische Draufsicht auf Partikel eines erfindungsgemäßen Ausgangswerkstoffs einer Sinterverbindung gemäß einer ersten Ausführungsform, welche erste und zweite Partikel umfasst;
- Fig. 2: eine schematische Draufsicht auf Partikel eines erfindungsgemäßen Ausgangswerkstoffs einer Sinterverbindung gemäß einer zweiten Ausführungsform, welche erste, zweite und dritte Partikel umfasst;
- Fig. 3: eine schematische Draufsicht auf Partikel eines erfindungsgemäßen Ausgangswerkstoffs einer Sinterverbindung gemäß einer dritten Ausführungsform, welche erste, zweite, dritte und vierte Partikel umfasst;
- Fig. 4a-f: schematische Querschnitte durch Ausgestaltungen von ersten Partikeln;
- Fig. 5a-e: schematische Querschnitte durch Ausgestaltungen von zweiten Partikeln;
- Fig. 6a-e: schematische Querschnitte durch Ausgestaltungen von dritten Partikeln;
- Fig. 7a,b: schematische Querschnitte durch Ausgestaltungen von vierten Partikeln;
- Fig. 8: einen schematischen Querschnitt durch eine erste Ausgestaltung einer elektronischen Schaltung;
- Fig. 9: einen schematischen Querschnitt durch eine zweite Ausgestaltung einer elektronischen Schaltung; und
- Fig. 10: einen schematischen Querschnitt durch einen Sinterofen bei der Herstellung einer Sinterverbindung beziehungsweise einer elektronischen Schaltung.

In den Figuren sind gleiche Bauteile und Bauteile mit der gleichen Funktion mit den gleichen Bezugszeichen gekennzeichnet.

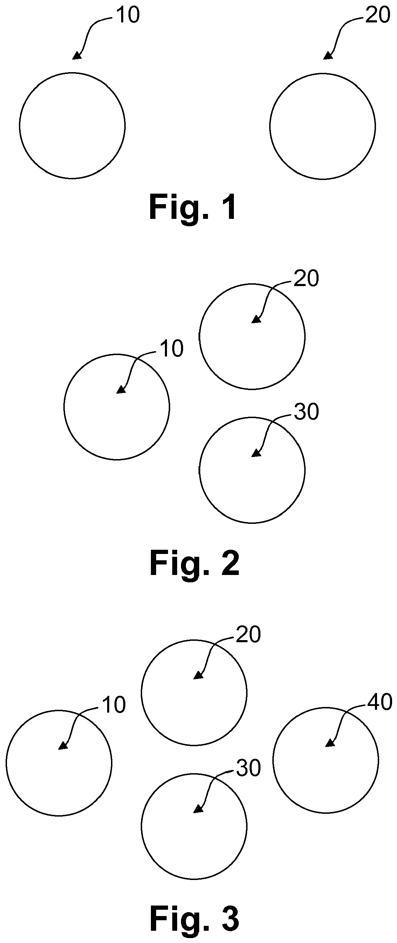

In Figur 1 sind schematisch erste Partikel 10 und zweite Partikel 20 gezeigt, die in einer ersten Ausführungsform in einem erfindungsgemäßen Ausgangswerkstoffs für eine Sinterverbindung vor gesehen sind.

In Figur 2 sind schematisch erste 10, zweite 20 und dritte 30 Partikel gezeigt, die in einer zweiten Ausführungsform in einem erfindungsgemäßen Ausgangswerkstoffs für eine Sinterverbindung vorgesehen sind.

In Figur 3 sind schematisch erste 10, zweite 20, dritte 30 und vierte 40 Partikel gezeigt, die in einer dritten Ausführungsform in einem erfindungsgemäßen Ausgangswerkstoffs für eine Sinterverbindung vorgesehen sind.

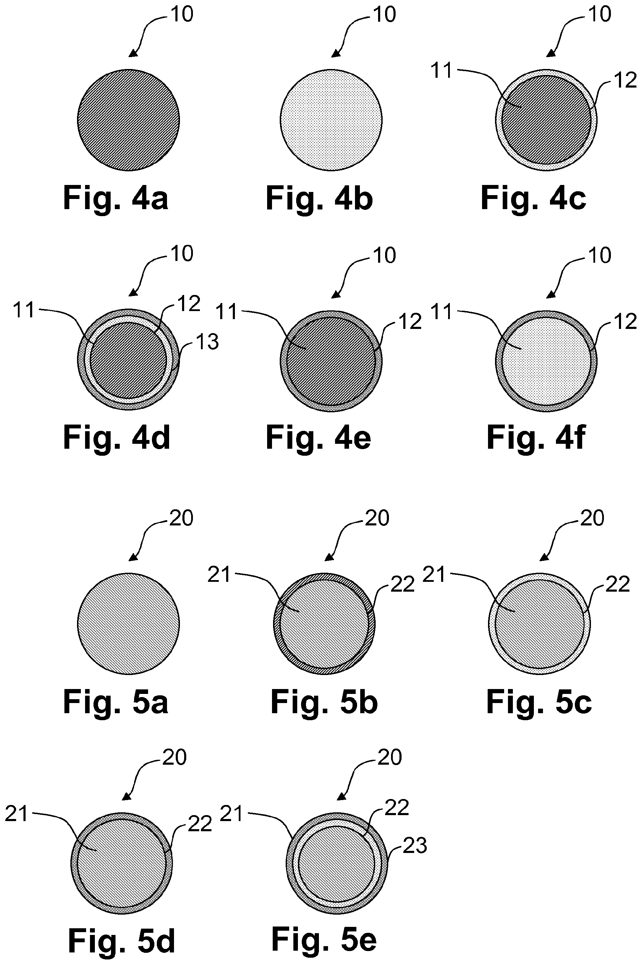

Der Ausgangswerkstoff kann im Rahmen der in den Figuren 1 bis 3 veranschaulichten Ausführungsformen metallhaltige, erste Partikel 10 einer oder mehrerer in den Figuren 4a bis 4f gezeigten Ausbildungen aufweisen. Beispielsweise kann es sich bei den ersten Partikeln 10 um edelmetall- und/oder kupferhaltige, insbesondere silberhaltige, Partikel handeln. Zum einfacheren Verständnis werden die Figuren im Folgenden anhand von silberhaltigen ersten Partikeln 10 erläutert. Figur 4a zeigt ein erstes Partikel 10, welches aus Silber in metallischer Form ausgebildet ist.

Figur 4b zeigt ein erstes Partikel 10, welches aus einer organischen oder anorganischen Silberverbindung, zum Beispiel Silbercarbonat (Ag₂CO₃) und/oder Silberoxid (Ag₂O, AgO), ausgebildet ist, welche durch eine Temperaturbehandlung in metallisches Silber umwandelbar ist.

Figur 4c zeigt ein erstes Partikel 10, welches einen Partikelkern 11 aus Silber in metallischer Form sowie eine darauf aufgebrachte erste Beschichtung 12 aus einer organischen oder anorganischen Silberverbindung, zum Beispiel Silbercarbonat und/oder Silberoxid, aufweist, welche durch eine Temperaturbehandlung in metallisches Silber umwandelbar ist.

Figur 4d zeigt ein erstes Partikel 10, welches einen Partikelkern 11 aus Silber in metallischer Form sowie eine darauf aufgebrachte erste Beschichtung 12 aus einer organischen oder anorganischen Silberverbindung, zum Beispiel Silbercarbonat und/oder Silberoxid, aufweist, welche durch eine Temperaturbehandlung in metallisches Silber umwandelbar ist. Darüber hinaus weist das in Figur 4d gezeigte Partikel 10 eine weitere auf der ersten Beschichtung 12 aufgebrachte Beschichtung 13 auf, welche ein Reduktionsmittel, zum Beispiel eine Fettsäure, enthält, mittels welchem die Reduktion der organischen oder anorganischen Silberverbindung, zu metallischem Silber durchführbar ist.

Figur 4e zeigt ein erstes Partikel 10, welches einen Partikelkern 11 aus Silber in metallischer Form sowie eine darauf aufgebrachte Reduktionsmittel, zum Beispiel Fettsäure, enthaltende erste Beschichtung 12 aufweist, wobei mittels des Reduktionsmittel die Reduktion einer organischen oder anorganischen Silberverbindung, zum Beispiel von Silbercarbonat und/oder Silberoxid, zu metallischem Silber durchführbar ist. Die organische oder anorganische Silberverbindung kann dabei Bestandteil eines anderen ersten 10, zweiten 20, dritten 30 oder vierten 40 Partikels sein.

Figur 4f zeigt ein erstes Partikel 10, welches einen Partikelkern 11 aus einer organischen oder anorganischen Silberverbindung, zum Beispiel Silbercarbonat und/oder Silberoxid aufweist, welche durch eine Temperaturbehandlung in metallisches Silber umwandelbar ist. Darüber hinaus weist das erste Partikel 10 eine auf den Partikelkern 11 aufgebrachte erste Beschichtung 12 auf welche ein Reduktionsmittel, zum Beispiel Fettsäure, enthält, mittels welchem die Reduktion der organischen oder anorganischen Silberverbindung, zu metallischem Silber durchführbar ist.

Figur 5a zeigt ein andersartiges zweites Partikel 20, welches anders als erfindungsgemäß aus elementarem Silicium und/oder Siliciumoxid ausgebildet ist.

Figur 5b zeigt ein zweites erfindungsgemäßes Partikel 20, welches einen Partikelkern 21 aus elementarem Silicium und/oder Siliciumdioxid und eine auf den Partikelkern aufgebrachte zweite Beschichtung 22 aus Silber, Platin oder Palladium in metallischer Form aufweist.

Figur 5c zeigt ebenfalls ein andersartiges zweites Partikel 20, welches anders als erfindungsgemäß einen Partikelkern 21 aus elementarem Silicium und/oder Siliciumdioxid sowie eine darauf aufgebrachte zweite Beschichtung 22 aus einer organischen oder anorganischen Silberverbindung, zum Beispiel Silbercarbonat und/oder Silberoxid, aufweist, welche durch eine Temperaturbehandlung in metallisches Silber umwandelbar ist.

Figur 5d zeigt ebenso ein andersartiges zweites Partikel 20, welches anders als erfindungsgemäß einen Partikelkern 21 aus elementarem Silicium und/oder Siliciumdioxid sowie eine darauf aufgebrachte zweite Beschichtung 22 aufweist, welche ein Reduktionsmittel, zum Beispiel Fettsäure, enthält, mittels welchem die Reduktion einer organischen oder anorganischen Silberverbindung, zum Beispiel von Silbercarbonat und/oder Silberoxid, welche Bestandteil eines anderen ersten 10, zweiten 20, dritten 30 oder vierten 40 Partikels ist, zu metallischem Silber durchführbar ist.

Figur 5e zeigt ebenfalls ein andersartiges zweites Partikel 20, welches anders als erfindungsgemäß einen Partikelkern 21 aus elementarem Silicium und/oder Siliciumdioxid sowie eine darauf aufgebrachte zweite Beschichtung 22 aus einer organischen oder anorganischen Silberverbindung, zum Beispiel Silbercarbonat und/oder Silberoxid, aufweist, welche durch eine Temperaturbehandlung in metallisches Silber umwandelbar ist. Darüber hinaus weist das in Figur 5e gezeigte Partikel 20 eine weitere auf der zweiten Beschichtung 22 aufgebrachte Beschichtung 23 auf, welche ein Reduktionsmittel, zum Beispiel eine Fettsäure, enthält, mittels welchem die Reduktion der organischen oder anorganischen Silberverbindung, zu metallischem Silber durchführbar ist.

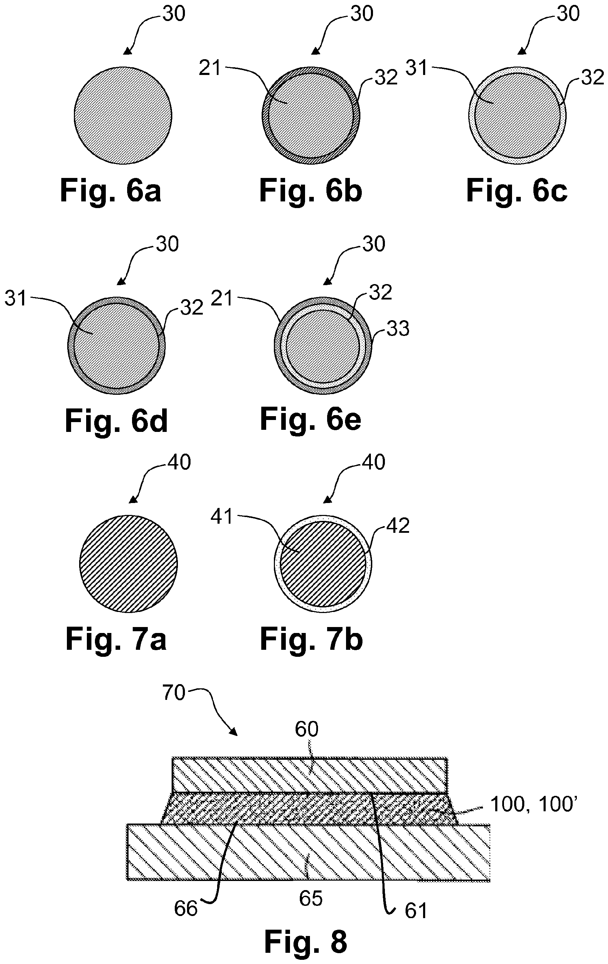

Figur 6a zeigt ein drittes Partikel 30, welches aus einem chemisch inerten und physikalisch stabilen Material, beispielsweise Siliciumcarbid (SiC), Aluminiumnitrid (AIN), Siliciumnitrid (Si₃N₄) und/oder Aluminiumoxid, ausgebildet ist.

Figur 6b zeigt ein drittes Partikel 30, welches einen Partikelkern 31 aus einem chemisch inerten und physikalisch stabilen Material, beispielsweise Siliciumcarbid (SiC), Aluminiumnitrid (AIN), Siliciumnitrid (Si₃N₄) und/oder Aluminiumoxid, und eine auf den Partikelkern aufgebrachte dritte Beschichtung 32 aus Silber, Platin oder Palladium in metallischer Form aufweist.

Figur 6c zeigt ein drittes Partikel 30, welches einen Partikelkern 31 aus einem chemisch inerten und physikalisch stabilen Material, beispielsweise Siliciumcarbid (SiC), Aluminiumnitrid (AIN), Siliciumnitrid (Si₃N₄) und/oder Aluminiumoxid, sowie eine darauf aufgebrachte zweite Beschichtung 32 aus einer organischen oder anorganischen Silberverbindung, zum Beispiel Silbercarbonat und/oder Silberoxid, aufweist, welche durch eine Temperaturbehandlung in metallisches Silber umwandelbar ist.

Figur 6d zeigt ein drittes Partikel 30, welches einen Partikelkern 31 aus einem chemisch inerten und physikalisch stabilen Material, beispielsweise Siliciumcarbid (SiC), Aluminiumnitrid (AIN), Siliciumnitrid (Si₃N₄) und/oder Aluminiumoxid, sowie eine darauf aufgebrachte dritte Beschichtung 32 aufweist, welche ein Reduktionsmittel, zum Beispiel Fettsäure, enthält, mittels welchem die Reduktion einer organischen oder anorganischen Silberverbindung, zum Beispiel von Silbercarbonat und/oder Silberoxid, welche Bestandteil eines anderen ersten 10, zweiten 20, dritten 30 oder vierten 40 Partikels ist, zu metallischem Silber durchführbar ist.

Figur 6e zeigt ein drittes Partikel 30, welches einen Partikelkern 31 aus einem chemisch inerten und physikalisch stabilen Material, beispielsweise Siliciumcarbid (SiC), Aluminiumnitrid (AIN), Siliciumnitrid (Si₃N₄) und/oder Aluminiumoxid, sowie eine darauf aufgebrachte dritte Beschichtung 32 aus einer organischen oder anorganischen Silberverbindung, zum Beispiel Silbercarbonat und/oder Silberoxid, aufweist, welche durch eine Temperaturbehandlung in metallisches Silber umwandelbar ist. Darüber hinaus weist das in Figur 6e gezeigte Partikel 30 eine weitere auf der dritte Beschichtung 32 aufgebrachte Beschichtung 33 auf, welche ein Reduktionsmittel, zum Beispiel eine Fettsäure, enthält, mittels welchem die Reduktion der organischen oder anorganischen Silberverbindung, zu metallischem Silber durchführbar ist.

Figur 7a zeigt ein viertes Partikel 40, welches ein Metall, zum Beispiel Zinn, enthält, welches durch eine Temperaturbehandlung eine Legierung mit Silber ausbildet und/oder einen niedrigeren Schmelzpunkt als metallisches Silber aufweist.

Figur 7b zeigt ein viertes Partikel 40, welches einen Partikelkern 41 aus einem Metall, zum Beispiel Zinn, aufweist, welches durch eine Temperaturbehandlung eine Legierung mit Silber ausbildet und/oder einen niedrigeren Schmelzpunkt als metallisches Silber aufweist. Darüber hinaus weist das in Figur 7b gezeigte vierte Partikel eine auf den Partikelkern 41 aufgebrachte vierte Beschichtung 42 aus einer organischen oder anorganischen Silberverbindung, zum Beispiel Silbercarbonat und/oder Silberoxid, auf, welche durch eine Temperaturbehandlung in metallisches Silber umwandelbar ist.

Figur 8 zeigt eine erste Ausführungsform einer elektronischen Schaltung 70, welche ein Substrat 65 mit mindestens einer Kontaktstelle 66 aufweist. Durch eine aus einem erfindungsgemäßen Ausgangswerkstoff 100 hergestellte Sinterverbindung 100' ist die Kontaktstelle 66 des Substrats 65 mit einer Kontaktstelle 61 eines Chips 60 verbunden.

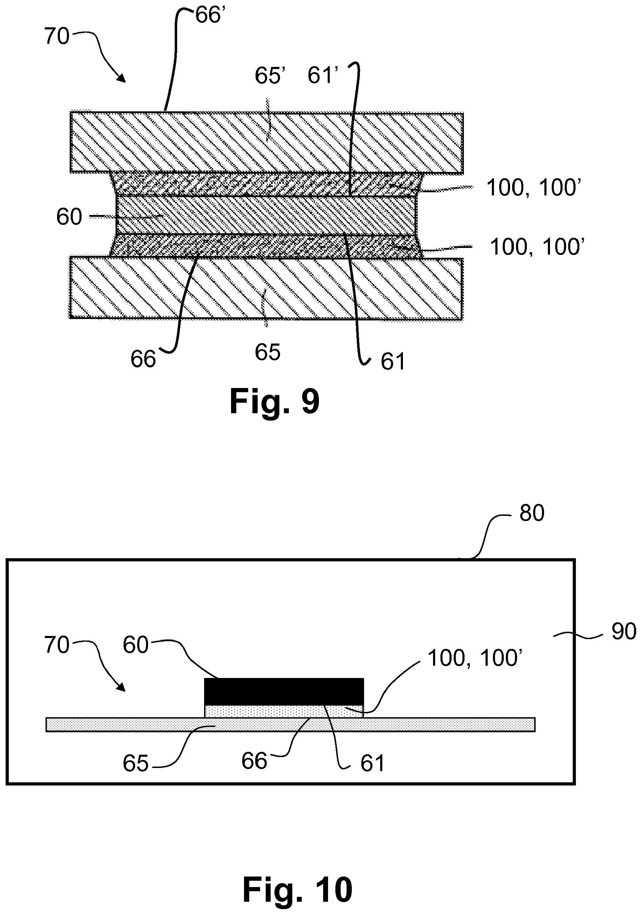

Figur 9 zeigt eine zweite Ausführungsform einer elektronischen Schaltung 70, welche ein erstes Substrat 65 mit mindestens einer Kontaktstelle 66 aufweist. Durch eine erste Sinterverbindung 100, welche aus einem erfindungsgemäßen Ausgangswerkstoff 100 hergestellt ist, ist die erste Kontaktstelle 66 des ersten Substrats 65 mit einer ersten Kontaktstelle 61 eines Chips 60 verbunden. Durch eine zweite Sinterverbindung 100, welche ebenfalls aus dem erfindungsgemäßen Ausgangswerkstoff 100 hergestellt ist, ist wiederum eine zweite Kontaktstelle 61' des Chips 60 mit einer Kontaktstelle 66' eines zweiten Substrats 65' verbunden.

In Figur 10 ist ein Sinterofen 80 gezeigt, sowie eine in einem Prozessraum 90 des Sinterofens 80 angeordnete elektronische Schaltung 70. Die elektronische Schaltung 70 weist ein Substrat 65 mit mindestens einer ersten Kontaktstelle 66 aus Kupfer auf. Auf dem Substrat 65 ist ein Chip 60 mit zumindest einer zweiten Kontaktstelle 61 aus einer Silberlegierung angeordnet. Zwischen der mindestens ersten Kontaktstelle 66 aus Kupfer und der zumindest zweiten Kontaktstelle 61 aus der Silberlegierung ist ein erfindungsgemäßer Ausgangswerkstoff 100 als Paste aufgetragen. Der Ausgangswerkstoff 100 enthält dabei anteilig eine Mischung von ersten 10 und zweiten 20 Partikeln entsprechend den Figuren 1 bis 4f und der Fig. 5b.

Zur Ausbildung einer Sinterverbindung 100' zwischen der mindestens ersten Kontaktstelle 66 des Substrates 65 und der zumindest zweiten Kontaktstelle 61 des Chips 60, wird die elektronische Schaltung 70 mit dem enthaltenen Ausgangswerkstoff 100 einer Temperaturbehandlung unterzogen. Zur Durchführung der Temperaturbehandlung enthält der Sinterofen 80 innerhalb des Prozessraumes 90 eine Heizvorrichtung. Im Prozessraum 90 liegt während der Temperaturbehandlung des Ausgangswerkstoffes 100 beispielsweise ein Vakuum oder eine Schutzgasatmosphäre vor.

Der Ausgangswerkstoff 100 wird beispielsweise als Paste appliziert, in welcher die ersten 10 und zweiten 20 Partikel und gegebenenfalls die dritten 30 und/oder vierten 40 Partikel in dispergierter Form vorliegen.

Infolge der Temperaturbehandlung der elektronischen Schaltung 70 werden im Ausgangswerkstoff 100 physikalische und/oder chemische Reaktionsprozesse ausgelöst. Dabei kann gegebenenfalls enthaltenes Reduktionsmittel, beispielsweise eine Fettsäure, mit einer gegebenenfalls enthaltenen organischen oder anorganischen Silberverbindung, beispielsweise Silbercarbonat und/oder Silberoxid, bereits bei einer Temperatur unterhalb der Sintertemperatur von Silber zu metallischem Silber reagieren. Durch die vorstehend beschriebenen Ausgestaltungen der Silberverbindungen enthaltenden Partikel, kann dabei eine weitestgehend vollständige Umwandlung in Silber erzielt werden.

Die metallhaltigen ersten Partikel 10 versintern zu einem elektrisch leitenden Sintergefüge. Dabei verhält sich das elementare Silizium und/oder Siliziumdioxid der zweiten Partikel 20 bzw. deren Partikelkerne inert. Die im Zusammenhang mit den Figuren 4c bis 7b erläuterten Beschichtungen 12,13,22,23,32,33,42 können dabei die Versinterung innerhalb des Sintergefüges unterstützen. Das elementare Silizium und/oder Siliziumdioxid der zweiten Partikel 20 liegt nach Ausbildung der Sinterverbindung 100' fein verteilt innerhalb der metallischen Silbermatrix des Sintergefüges 100' vor. Zusätzlich können in der Silbermatrix auch dritte 30 und/oder vierte 40 Partikel entsprechend den Figur 6a bis 7b mitversintert werden.

Die in dem Ausgangswerkstoff 100 gegebenenfalls als Mischung mit den ersten und zweiten Partikeln 10 bzw. 20 enthaltenen dritten Partikel 30 beziehungsweise zumindest deren Partikelkerne 31, beispielsweise aus Siliciumcarbid, Aluminiumnitrid, Siliciumnitrid, Aluminiumoxid, verhalten sich beim Versintern ebenso wie das im Ausgangswerkstoff enthaltene elementare Silizium und/oder Siliziumdioxid inert.

Die in dem Ausgangswerkstoff 100 gegebenenfalls als Mischung mit den ersten und zweiten Partikeln 10 bzw. 20 enthaltenen vierte Partikel 40, beispielsweise aus Zinn, schmelzen während der Temperaturbehandlung frühzeitig auf und unterstützen einen stofflichen Kontakt aller im Ausgangswerkstoff 100 enthaltenen Partikel 10, 20, 30, 40. Zusätzlich können die vierten Partikel 40 Legierungen mit den Bestandteilen der ersten 10 Partikel und gegebenenfalls Partikelbeschichtungen 12,13,22,32,42 bilden. Diese Legierungen liegen dann als duktile Phasen innerhalb der im Sintergefüge ausgebildeten Silbermatrix vor.

Ebenso erfolgt mittels der gebildeten Sinterverbindung 100' eine Kontaktierung der ersten und zweiten Kontaktstelle 61, 66 des Substrates bzw. des Chips 65. Eine Kontaktierung der ersten Kontaktstelle 66 aus Kupfer während der Temperaturbehandlung ohne Korrosionserscheinungen ist möglich, da die Kontaktierung unter Vakuum oder einer Schutzgasatmosphäre erfolgt. Dadurch bleibt ein unedles Material, wie beispielsweise aus Kupfer, auch während der Temperaturbehandlung zur Ausbildung der Sinterverbindung 100' frei von Oxidationsprodukten.

## Patentansprüche

1. Ausgangswerkstoff (100) für eine Sinterverbindung (100'), umfassend
- metallhaltige erste Partikel (10) und
- zweite Partikeln (20),
**dadurch gekennzeichnet, dass**
die zweiten Partikel (20) zumindest anteilig elementares Silicium und/oder Siliciumdioxid enthalten, wobei die zweiten Partikel (20) einen Partikelkern (21) mit einer darauf aufgetragenen zweiten Beschichtung (22) aufweisen, wobei die zweite Beschichtung (22) mindestens ein Metall umfasst, welches ausgewählt ist aus der Gruppe bestehend aus Silber, Platin, Palladium, Gold, Zinn und Kombinationen davon.

2. Ausgangswerkstoff nach Anspruch 1, wobei das elementare Silicium und/oder Siliciumdioxid amorphes elementares Silicium und/oder amorphes Siliciumdioxid ist.

3. Ausgangswerkstoff nach Anspruch 1 oder 2, wobei die zweiten Partikel (20) sphärische, insbesondere im Wesentlichen runde, beispielsweise im Wesentlichen kugelförmige, Partikel sind.

4. Ausgangswerkstoff nach einem der Ansprüche 1 bis 3, wobei die zweiten Partikel (20) einen Partikelkern (21) aus elementarem Silicium und/oder Siliciumdioxid aufweisen.

5. Ausgangswerkstoff nach einem der Ansprüche 1 bis 4, wobei die ersten Partikel (10) edelmetall- und/oder kupferhaltige, insbesondere silberhaltig, sind, insbesondere wobei die ersten Partikel (10) mindestens ein Edelmetall und/oder Kupfer, insbesondere Silber, in metallischer Form und/oder mindestens eine organische oder anorganische Edelmetall- und/oder Kupferverbindung, insbesondere Silberverbindung, enthalten, insbesondere wobei die organische oder anorganische Edelmetall- und/oder Kupferverbindung, insbesondere Silberverbindung, durch eine Temperaturbehandlung in das mindestens eine zugrunde liegende Metall in metallischer Form umwandelbar ist.

6. Ausgangswerkstoff nach einem der Ansprüche 1 bis 5, wobei die ersten Partikel (10) einen Partikelkern (11) mit einer darauf aufgetragenen ersten Beschichtung (12) aufweisen.

7. Ausgangswerkstoff nach einem der Ansprüche 1 bis 6, wobei der Ausgangswerkstoff weiterhin dritte Partikel (30) umfasst, wobei die dritten Partikel (30) zumindest anteilig ein, insbesondere chemisch inertes und physikalisch stabiles, Partikelkernmaterial enthalten, welches bei 20 °C einen geringeren thermischen Längenausdehnungskoeffizienten α als das oder die Metalle der ersten Partikel (10) in metallischer Form aufweist und/oder welches bei 20 °C einen thermischen Längenausdehnungskoeffizienten α von ≤ 15 10⁻⁶K⁻¹, insbesondere von ≤ 10 10⁻⁶K⁻¹ oder von ≤ 7,5 10⁻⁶K⁻¹, vorzugsweise von ≤ 5 10⁻⁶K⁻¹, aufweist.

8. Ausgangswerkstoff nach Anspruch 7, wobei das Partikelkernmaterial der dritten Partikel (30) bei 20 °C und 50 % Luftfeuchte eine Wärmeleitfähigkeit λ_{20/50} von ≥ 15 Wm⁻¹K⁻¹ oder ≥ 25 Wm⁻¹K⁻¹, vorzugsweise von ≥ 50 Wm⁻¹K⁻¹, insbesondere von ≥ 100 Wm⁻¹K⁻¹, aufweist.

9. Ausgangswerkstoff nach Anspruch 7 oder 8, wobei das Partikelkernmaterial der dritten Partikel (30) ausgewählt ist aus der Gruppe bestehend aus Siliciumcarbid, Aluminiumnitrid, Siliciumnitrid, Aluminiumoxid, metallischem Wolfram, metallischem Molybdän, metallischem Chrom, Borcarbid, Berylliumoxid, Bornitrid sowie Kombinationen davon.

10. Ausgangswerkstoff nach einem der Ansprüche 7 bis 9, wobei die dritten Partikel (30) einen Partikelkern (31) und eine darauf aufgetragene dritte Beschichtung (32) aufweisen, wobei die dritte Beschichtung (32) mindestens ein Metall umfasst, welches ausgewählt ist aus der Gruppe bestehend aus Silber, Platin, Palladium, Gold, Zinn und Kombinationen davon.

11. Ausgangswerkstoff nach einem der Ansprüche 1 bis 10, wobei der Ausgangswerkstoff (100), bezogen auf das Gesamtgewicht der Bestandteile, ≥ 5 Gew.-%, insbesondere ≥ 10 Gew.-%, beispielsweise ≥ 20 Gew.-% oder ≥ 25 Gew.-%, und/oder ≤ 60 Gew.-%, insbesondere ≤ 50 Gew.-%, an zweiten Partikel (20) und ≥ 25 Gew.-% bis ≤ 80 Gew.-% an ersten Partikeln umfasst.

## Claims

1. Starting material (100) for a sintered bond (100'), which comprises
- metal-containing first particles (10) and
- second particles (20),
**characterized in that** the second particles (20) contain at least a proportion of elemental silicon and/or silicon dioxide, where the second particles (20) have a particle core (21) with a second coating (22) applied thereto, where the second coating (22) comprises at least one metal selected from the group consisting of silver, platinum, palladium, gold, tin and combinations thereof.

2. Starting material according to Claim 1, wherein the elemental silicon and/or silicon dioxide is amorphous elemental silicon and/or amorphous silicon dioxide.

3. Starting material according to Claim 1 or 2, wherein the second particles (20) are spherical, in particular essentially round, for example essential ball-shaped, particles.

4. Starting material according to any of Claims 1 to 3, wherein the second particles (20) have a particle core (21) composed of elemental silicon and/or silicon dioxide.

5. Starting material according to any of Claims 1 to 4, wherein the first particles (10) are noble metal-containing and/or copper-containing, in particular silver-containing, and in particular the first particles (10) contain at least one noble metal and/or copper, in particular silver, in metallic form and/or at least one organic or inorganic noble metal compound and/or copper compound, in particular silver compound, where, in particular, the organic or inorganic noble metal compound and/or copper compound, in particular silver compound, can be converted into the at least one parent metal in metallic form by a thermal treatment.

6. Starting material according to any of Claims 1 to 5, wherein the first particles (10) have a particle core (11) with a first coating (12) applied thereto.

7. Starting material according to any of Claims 1 to 6, wherein the starting material further comprises third particles (30), where the third particles (30) contain at least a proportion of an, in particular chemically inert and physically stable, particle core material, which has, at 20°C, a lower coefficient of thermal expansion α than the metal or metals of the first particles (10) in metallic form and/or which has a coefficient of thermal expansion α at 20°C of ≤ 15 10⁻⁶K⁻¹, in particular ≤ 10 10⁻⁶K⁻¹ or ≤ 7.5 10⁻⁶K⁻¹, preferably ≤ 5 10⁻⁶K⁻¹.

8. Starting material according to Claim 7, wherein the particle core material of the third particles (30) has a thermal conductivity λ_{20/50} at 20°C and 50% atmospheric humidity of ≥ 15 Wm⁻¹K⁻¹ or ≥ 25 Wm⁻¹K⁻¹, preferably ≥ 50 Wm⁻¹K⁻¹, in particular ≥ 100 Wm⁻¹K⁻¹.

9. Starting material according to Claim 7 or 8, wherein the particle material of the third particles (30) is selected from the group consisting of silicon carbide, aluminium nitride, silicon nitride, aluminium oxide, metallic tungsten, metallic molybdenum, metallic chromium, boron carbide, beryllium oxide, boron nitride and combinations thereof.

10. Starting material according to any of Claims 7 to 9, wherein the third particles (30) have a particle core (31) and a third coating (32) applied thereto, where the third coating (32) comprises at least one metal selected from the group consisting of silver, platinum, palladium, gold, tin and combinations thereof.

11. Starting material according to any of Claims 1 to 10, wherein the starting material (100) comprises, based on the total weight of the constituents, ≥ 5% by weight, in particular ≥ 10% by weight, for example ≥ 20% by weight or ≥ 25% by weight, and/or ≤ 60% by weight, in particular ≤ 50% by weight, of second particles (20) and from ≥ 25% by weight to ≤ 80% by weight of first particles.

## Revendications

1. Matériau de départ (100) pour un composé fritté (100'), comprenant
- des premières particules (10) contenant un métal et
- des deuxièmes particules (20),
**caractérisé en ce que**
les deuxièmes particules (20) contiennent au moins en partie du silicium élémentaire et/ou du dioxyde de silicium, les deuxièmes particules (20) présentant un noyau de particule (21) doté d'un deuxième revêtement (22) appliqué dessus, le deuxième revêtement (22) comprenant au moins un métal, qui est choisi dans le groupe constitué par l'argent, le platine, le palladium, l'or, l'étain et des combinaisons correspondantes.

2. Matériau de départ selon la revendication 1, le silicium élémentaire et/ou le dioxyde de silicium étant du silicium élémentaire amorphe et/ou du dioxyde de silicium amorphe.

3. Matériau de départ selon la revendication 1 ou 2, les deuxièmes particules (20) étant des particules sphériques, en particulier essentiellement rondes, par exemple essentiellement en forme de billes.

4. Matériau de départ selon l'une quelconque des revendications 1 à 3, les deuxièmes particules (20) présentant un noyau de particule (21) composé de silicium élémentaire et/ou de dioxyde de silicium.

5. Matériau de départ selon l'une quelconque des revendications 1 à 4, les premières particules (10) contenant un métal noble et/ou du cuivre, en particulier contenant de l'argent, en particulier les premières particules (10) contenant au moins un métal noble et/ou du cuivre, en particulier de l'argent, sous forme métallique et/ou au moins un composé organique ou inorganique de métal noble et/ou de cuivre, en particulier un composé de l'argent, en particulier le composé organique ou inorganique de métal noble et/ou de cuivre, en particulier le composé de l'argent, étant transformable en l'au moins un métal sous-jacent sous forme métallique par un traitement de température.

6. Matériau de départ selon l'une quelconque des revendications 1 à 5, les premières particules (10) présentant un noyau de particule (11) doté d'un premier revêtement (12) appliqué sur celui-ci.

7. Matériau de départ selon l'une quelconque des revendications 1 à 6, le matériau de départ comprenant en outre des troisièmes particules (30), les troisièmes particules (30) contenant au moins en partie un matériau de noyau de particule, en particulier chimiquement inerte et physiquement stable, qui présente à 20 °C un coefficient thermique α d'extension en longueur plus petit que celui du métal ou des métaux des premières particules (10) sous forme métallique et/ou qui présente à 20 °C un coefficient thermique α d'extension en longueur de ≤ 15 10⁻⁶ K⁻¹, en particulier de ≤ 10 10⁻⁶ K⁻¹ ou de ≤ 7,5 10⁻⁶ K⁻¹, de préférence de ≤ 5 10⁻⁶ K⁻¹.

8. Matériau de départ selon la revendication 7, le matériau de noyau de particule des troisièmes particules (30) à 20 °C et 50 % d'humidité dans l'air présentant une conductivité de chaleur λ_{20/50} de ≥ 15 Wm⁻¹K⁻¹ ou ≥ 25 Wm⁻¹K⁻¹. de préférence de ≥ 50 Wm⁻¹K⁻¹, en particulier de ≥ 100 Wm⁻¹K⁻¹.

9. Matériau de départ selon la revendication 7 ou 8, le matériau de noyau de particule des troisièmes particules (30) étant choisi dans le groupe constitué par le carbure de silicium, le nitrure d'aluminium, le nitrure de silicium, l'oxyde d'aluminium, le tungstène métallique, le molybdène métallique, le chrome métallique, le carbure de bore, l'oxyde de béryllium, le nitrure de bore ainsi que des combinaisons correspondantes.

10. Matériau de départ selon l'une quelconque des revendications 7 à 9, les troisièmes particules (30) présentant un noyau (31) de particule et un troisième revêtement (32) appliqué sur celui-ci, le troisième revêtement (32) comprenant au moins un métal, qui est choisi dans le groupe constitué par l'argent, le platine, le palladium, l'or, l'étain et des combinaisons correspondantes.

11. Matériau de départ selon l'une quelconque des revendications 1 à 10, le matériau de départ (100), par rapport au poids total des composants, comprenant ≥ 5 % en poids, en particulier ≥ 10 % en poids, par exemple ≥ 20 % en poids ou ≥ 25 % en poids, et/ou ≥ 60 % en poids, en particulier ≥ 50 % en poids, de deuxièmes particules (20) et ≥ 25 % en poids à ≤ 80 % en poids de premières particules.
